(19) Europäisches Patentamt

European Patent Office

Office européen des brevets

(11) Veröffentlichungsnummer: **0 174 022**
**A1**

## (12) EUROPÄISCHE PATENTANMELDUNG

(21) Anmeldenummer: 85111192.2

(22) Anmeldetag: 04.09.85

(51) Int. Cl.⁴: **H01L 29/72** , H01L 29/08

(30) Priorität: 06.09.84 DE 3432815

(43) Veröffentlichungstag der Anmeldung:
**12.03.86 Patentblatt 86/11**

(84) Benannte Vertragsstaaten:
**AT DE FR GB IT NL**

(71) Anmelder: **Siemens Aktiengesellschaft**
**Berlin und München Wittelsbacherplatz 2**
**D-8000 München 2(DE)**

(72) Erfinder: **Roloff, Herbert F., Dr. Dipl.-Phys.**
**Akademiestrasse 21**
**D-8000 München 40(DE)**

(54) **Transistorstruktur.**

㉗ Die Erfindung gibt eine Struktur für einen vertikalen pnp-Transistor an, dessen Emitter- und Kollektoranschlußzonen (11, 12) sich oberhalb entgegengesetzter Endbereiche einer mit der Kollektoranschlußzone (12) verbundenen Buried-Layer (4) befinden und der sowohl hohe Verstärkung als auch hohe Stromtragfähigkeit bei einem mit npn-Transistoren vergleichbaren Flächenbedarf besitzt.

FIG 3

Die Erfindung betrifft eine Transistorstruktur nach dem Oberbegriff des Patentanspruchs 1.

Eine derartige Transistorstruktur bezeichnet man als vertikalen pnp-Transistor. Vertikale Transistoren besitzen gegenüber lateralen Transistoren unter anderem den Vorteil, daß der Strom nicht an der Oberfläche fließt und deshalb Oberflächeneffekte nur einen geringen Einfluß auf die Transistorfunktion ausüben. Laterale Transistoren erfordern aufgrund ihres Aufbaus, bei dem eine Emitterzone von einem durch den Basisbereich getrennten Kollektorgraben umgeben ist, aufgrund unerwünschter Unterätzungen und Verbreiterungen von Diffusionszonen eine relativ große Basisweite. Damit verbunden ist nur bei kleinen Strömen ein hoher Verstärkungsfaktor, während bei höheren Strömen die Verstärkung stark abnimmt. Vertikale Transistoren besitzen dagegen eine geringere Basisweite und einen hohen, weniger stromabhängigen Stromverstärkungsfaktor sowie eine um etwa zwei Größenordnungen höhere Stromtragfähigkeit.

Nach dem Stand der Technik wird ein vertikaler pnp-Transistor in einer Epitaxiewanne auf dem Halbleitersubstrat gebildet, die durch Isolationswände von anderen Bereichen des Halbleiterkristalls isoliert ist. Im Innenbereich zwischen den Isolationswänden befinden sich zwei Buried-Layers (vergrabene Schichten), von denen die erste, n-dotierte, gegenüber dem Halbleitersubstrat eine Isolationswanne für die zweite, p-dotierte Buried- Layer bildet, die sich aus der ersten Buried-Layer herausin die Epitaxieschicht erstreckt. Etwa zentral oberhalb der zweiten Buried-Layer befindet sich eine p-dotierte Anschlußzone, die den Emitter bildet. Die Emitteranschlußzone umgibt ein ebenfalls p-dotierter Graben, der bis in die zweite Buried-Layer hinabreicht und mit ihr zusammen als Kollektor dient, der in einem Bereich des Grabens eine Anschlußzone besitzt. Eine n-dotierte Basisanschlußzone ist zwischen der Emitteranschlußzone und dem Kollektorgraben angeordnet.

Ein derartig aufgebauter vertikaler pnp-Transistor benötigt gegenüber npn-Transistoren vergleichsweise viel Platz, da innerhalb der durch die Isolationswände gebildeten Wanne ein Kollektorgraben existiert, der die Emitteranschlußzone umschließt.

Der Erfindung liegt die Aufgabe zugrunde, eine Struktur für einen vertikalen pnp-Transistor anzugeben, die einen geringen Platzbedarf hat.

Diese Aufgabe wird bei einer Struktur der eingangs erwähnten Art erfindungsgemäß durch die Merkmale des kennzeichnenden Teils des Patentanspruchs 1 gelöst.

Ausgestaltungen des Erfindungsgedankens sind in Unteransprüchen gekennzeichnet.

Die Erfindung wird im folgenden anhand dreier in den Figuren der Zeichnung dargestellter Schnitte durch Halbleiterstrukturen näher erläutert, die sich bei einer als Ausführungsbeispiel anzusehenden Herstellung einer erfindungsgemäßen Transistorstruktur ergeben. Dabei sind gleiche Elemente mit gleichen Bezugszeichen versehen.

Es zeigt:

Fig. 1 einen Schnitt durch eine Halbleiteranordnung nach dem Aufbringen einer Epitaxieschicht,

Fig. 2 einen Schnitt durch eine Halbleiteranordnung vor der Dotierung der Anschlußzonen und

Fig. 3 einen Schnitt durch einen erfindungsgemäßen vertikalen pnp-Transistor vor Aufbringen der metallischen Anschlußkontakte.

Grundgedanke der Erfindung ist es, die von dem vertikalen pnp-Transistor beanspruchte Fläche dadurch zu verringern, daß die Emitteranschlußzone nicht mehr vollständig von einem Kollektorgraben umschlossen wird. Dabei ist es vorteilhaft, die Basisanschlußzone auf die der Kollektoranschlußzone abgewandte Seite der Emitteranschlußzone zu verlegen. Wenn die Transistorstruktur Teil einer integrierten Schaltung ist, ist es vorteilhaft, möglichst schmale Isolationswände zur Realisierung einer Wanne vorzusehen, in der der Transistor gebildet wird.

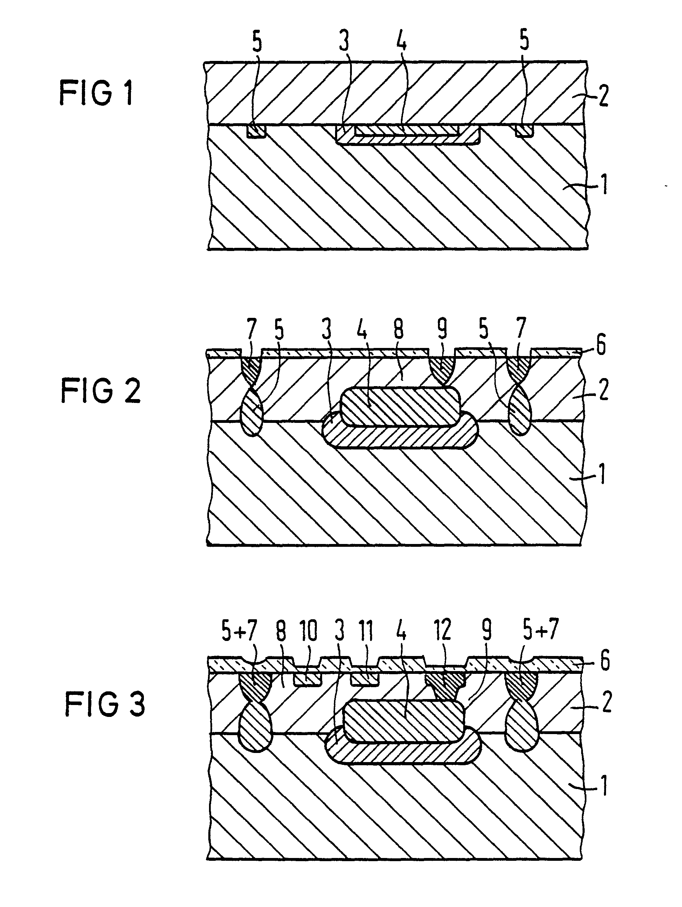

Zur Herstellung eines Transistors mit erfindungsgemäßer Struktur werden gemäß Fig. 1 zunächst in einem Halbleitersubstrat 1 vom p-Leitfähigkeitstyp vor dem Aufbringen einer Epitaxieschicht 2 dotierte Zonen 3 bis 5 erzeugt, als erstes eine $n^+$ -dotierte Zone 3, die gegenüber dem Halbleitersubstrat 1 eine Isolationswanne für eine darin eingebettete $p^+$ -dotierte Zone 4 bildet. Im gleichen Prozeßschritt wie die Zone 4 wird ein Graben 5 mit ebenfalls $p^+$ -Leitfähigkeit dotiert, der die Zone 3 im Abstand umschließt. Zur Herstellung der dotierten Zonen 3 bis 5 lassen sich die bekannten Techniken einsetzen, bevorzugt werden die Dotierungen jedoch implantiert, um vor allem möglichst homogene Zonen 3 und 4 zu erhalten. Außerdem muß die Zone 3, um eine Isolation der Zone 4 vom Substrat zu gewährleisten diese lateral völlig umschließen und sich tiefer und weiter als diese in das Halbleitersubstrat 1 erstrecken. Nach den so erfolgten Dotierungen wird die das Halbleitersubstrat 1 und die Zonen 3 bis 5 bedeckende Epitaxieschicht 2 mit n-oder $n^-$-Leitfähigkeit aufgebracht. Zur besseren Übersichtlichkeit ist in Fig. 1 ein mit dem Auftragen der Epitaxieschicht 2 beginnendes, thermisch bedingtes Vorwachsen der Zonen 3 bis 5, insbesondere in die Epitaxieschicht 2 selbst, nicht skizziert. Die Zonen 3 und 4 heißen nachfolgend erste (3) und zweite (4) Buried-Layer (vergrabene Schicht).

In weiteren Prozeßschritten werden in der epitaktischen Schicht 2 oberhalb des die erste Buried-Layer 3 umschließenden, von der Epitaxieschicht 2 abgedeckten $p^+$-dotierten Grabens 5 ein korrespondierender, $p^+$ $^+$-dotierter Graben und oberhalb eines Endbereiches der zweiten Buried-Layer 4 ein $p^+$ $^+$-dotierter Napf gebildet. Die Herstellung erfolgt wieder mit ansich bekannten Techniken, bevorzugt jedoch durch Diffusion, obwohl auch eine Implantation möglich ist.

Fig. 2 zeigt einen Schnitt durch eine Halbleiteranordnung vor der Dotierung der Anschlußzonen für eine gemäß dem Ausführungsbeispiel herzustellende erfindungsgemäße Transistorstruktur.

Vorausgegangen ist die Dotierung der $p^+$ $^+$-leitfähigen Zonen in der Epitaxieschicht 2 durch Diffusion und eine damit verbundene Temperaturbehandlung der Halbleiteranordnung. Skizziert ist die die Epitaxieschicht 2 abdeckende $SiO_2$-Schicht 6 mit den für die Diffusion geätzten Fenstern.

Die Temperaturbehandlung bewirkt das Eindiffundieren von Fremdatomen aus dem Dotierstoff in die Epitaxieschicht 2 und ein Vorwachsen der in vorangegangenen Herstellungsschritten erzeugten dotierten Zonen 3 bis 5 in Bereiche mit niedrigerer Dotierungskonzentration. Dabei wachsen der $p^+$-dotierte Graben 5 und der korrespondierende $p^+$ $^+$-dotierte Graben 7 jeweils so tief in die epitaktische Schicht 2 hinein, bis sie sich gegenseitig durchdringen und eine durchgehende $p^+$- bzw. $p^+$ $^+$-dotierte Isolationswand 5 + 7 entsteht, die eine Wanne 8, in der der Transistor gebildet wird, von den übrigen Bereichen der Epitaxischicht 2 abtrennt. Im Hinblick auf die Aufgabe, eine Transistorstruktur anzugeben, die einen möglichst geringen Platzbedarf hat, ist es insbesondere für integrierte Schaltkreise vorteilhaft, die Isolationswand 5 + 7 durch das thermisch bedingte Gegeneinanderwachsen zweier jeweils für sich erzeugter dotierter Zonen 5 und 7 zu erzeugen, da auf diese Weise die Isolationswand schmaler gerät als bei einer einzigen Dotierung und anschließender Temperaturbehandlung einer Zone im Halbleitersubstrat 1 oder in der Epitaxieschicht 2.

Ebenfalls bei der gleichen, zum erwähnten Diffusionsprozeß gehörenden Temperaturbehandlung wachsen die beiden Buried-Layers 3 und 4 jeweils weiter, vor allem in die Epitaxieschicht 2 hinein. Gleichzeitig diffundiert von der Oberfläche der Epitaxischicht der $p^{++}$-dotierte Napf in die Epitaxieschicht 2 hinein, der zweiten Buried-Layer 4 soweit entgegen, bis sich diese und der aus dem $p^{+}+$-dotierten Napf entstehende Kanal 9 gegenseitig durchdringen. Es ist notwendig für die herzustellende Transistorstruktur, daß die zweite Buried-Layer 4 schneller in die Epitaxieschicht 2 vorwächst als die sie vom Substrat isolierende erste Buried-Layer 3. Verantwortlich für das schnellere Vorwachsen der Buried-Layer 4 sind die unterschiedlichen Diffusionskoeffizienten der beiden verwendeten Dotierstoffe, beispielsweise Arsen für die $n^{+}$-Dotierung der ersten Buried-Layer 3 und Bor für die $p^{+}$-Dotierung der zweiten Buried-Layer 4.

Fig. 3 zeigt einen Schnitt durch einen nach diesem Ausführungsbeispiel hergestellten erfindungsgemäßen vertikalen pnp-Transistor nach erfolgter Basisdiffusion und vor Aufbringen der metallischen Kontakte. Mit der ansich bekannten Basisdiffusion werden die Anschlußzonen für die Metallkontakte hergestellt, wobei die Basisanschlußzone 10 $n^{+}$- und die Emitterzone 11 sowie die Kollektoranschlußzone 12 jeweils $p^{+}$-Dotierung aufweisen. Die in Fig. 2 bereits vorhandenen dotierten Zonen wachsen aufgrund der mit der Basisdiffusion verbundene Temperaturbehandlungen der Halbleiteranordnung jeweils tiefer bzw. weiter in das Halbleitersubstrat 1 und/oder die epitaktische Schicht 2 hinein, und es bildet sich eine $SiO_2$-Schicht 6.

Die $p^{+}$-dotierte Kollektoranschlußzone 12 bildet zusammen mit dem $p^{+}+$-dotierten Kanal 9 und der $p^{+}$-dotierten Buried-Layer 4 den Kollektor. Die gleichfalls $p^{+}$-dotierte Emitterzone 11 befindet sich oberhalb des der Kollektoranschlußzone 12 entgegengesetzten Endbereiches der zweiten Buried-Layer 4. Da die Kollektoranschlußzone 12 und der zur zweiten Buried-Layer 4 führende Kanal 9 nur auf einer Seite der Emitteranschlußzone 11 angeordnet sind und der Kanal 9 diese Emitteranschlußzone nicht, wie nach dem Stand der Technik üblich, in Form eines Grabens umschließt, läßt sich für eine in Fig. 3 dargestellte erfindungsgemäße Struktur eines vertikalen pnp-Transistors erhebliche Baulänge einsparen, wie beispielsweise in der Zeichenebene der Figuren dargestellt. Auch die senkrecht zur Zeichenebene der Figuren zu denkende Baubreite läßt sich durch eine derartige Transistorstruktur erheblich verringern.

Die $n^{+}$-dotierte Basisanschlußzone 10 kann zwischen der Emitterzone 11 und der Kollektoranschlußzone 12 liegen, wie es dem vertikalen pnp-Transistor nach dem Stand der Technik entspricht. Da üblicherweise der Abstand zwischen der Basis- und Kollektoranschlußzone größer als der Abstand zwischen der Basis- und Emitteranschlußzone gewählt wird, ist es jedoch vorteilhaft, die Basisanschlußzone 10 auf die der Kollektoranschlußzone 12 abgewandte Seite der Emitteranschlußzone 11 zu verlegen. Dabei ist es weiterhin vorteilhaft, die drei An schlußzonen 10, 11 und 12 in Reihe anzuordnen.

Absolute Maßangaben für die Abstände der Anschlußzonen 10 bis 12 untereinander als auch zur Isolationswand 5 und 7 lassen sich schwer angeben, da sie sich nach den versorgungsspannungsabhängigen zulässigen Werten für die elektrische Feldstärke richten; sie liegen jedoch etwa bei 10 µm. Insgesamt ergibt sich für den erfindungsgemäßen vertikalen pnp-Transistor ein Flächenbedarf, der etwa halb so groß wie bei einem vertikalen oder lateralen pnp-Transistor nach dem Stand der Technik und etwa gleich groß wie bei einem npn-Transistor ist.

Die Emitterzone 11 und die Kollektoranschlußzone 12 können, unter Berücksichtigung der zulässigen Feld-.stärkewerte relativ nahe beieinander liegen, da die Basisanschlußzone 10 nicht zwischen der Emitteranschlußzone 11 und der Kollektoranschlußzone 12 liegt. Der Zwischenraum in der Epitaxieschicht 2 zwischen der Emitterzone 11 und der zweiten Buried-Layer 4 gibt die eigentliche Basisweite an, die sich auf etwa 3 µm einstellen läßt.

Beim erfindungsgemäßen vertikalen pnp-Transistor entfallen die bei lateralen pnp-Transistoren bekannten Nachteile bezüglich des Stromverstärkungsfaktors, gleichzeitig bietet er die Vorteile einer etwa zwei Größenordnungen höheren Stromtragfähigkeit. Hinsichtlich der durch die inneren Kapazitäten und die maßgeblichen Bahnwiderstände bestimmten Schnelligkeit schneidet der erfindungsgemäße vertikale pnp-Transistor geringfügig schlechter ab als ein vertikaler pnp-Transistor nach dem Stand der Technik, er ist aber erheblich schneller als ein lateraler pnp-Transistor.

**Ansprüche**

1. Transistorstruktur mit einer auf einem Halbleitersubstrat vom ersten Leitfähigkeitstyp epitaktisch aufgetragenen Schicht vom zweiten Leitfähigkeitstyp, in der durch in das Halbleitersubstrat reichende Isolationswände vom ersten Leitfähigkeitstyp eine Wanne gebildet ist, einer ersten hochdotierten Buried-Layer vom zweiten Leitfähigkeitstyp, in die eine sich bis in die epitaktische Schicht erstreckende zweite Buried-Layer vom ersten Leitfähigkeitstyp isoliert vom Halbleitersubstrat eingebettet ist, drei dotierten Zonen, von denen eine vom zweiten Leitfähigkeitstyp für den Basisanschluß und jeweils eine vom ersten Leitfähigkeitstyp für den Emitter- und Kollektoranschluß'vorgesehen ist, und einer die Kollektoranschlußzone und die zweite Buried-Layer verbindenden Zone vom ersten Leitfähigkeitstyp, wobei diese Bereiche den Kollektor bilden, **dadurch gekennzeichnet,** daß die Emitterzone (11) und die Kollektoranschlußzone (12) oberhalb entgegengesetzter Endbereiche der zweiten Buried-Layer (4) angeordnet sind.

2. Transistorstruktur nach Anspruch 1, **dadurch gekennzeichnet,** daß die Basisanschlußzone (10) auf der der Kollektoranschlußzone (12) abgewandten Seite der Emitteranschlußzone (11) angeordnet ist.

3. Transistorstruktur nach Anspruch 1 oder 2, **dadurch gekennzeichnet,** daß die drei Anschlußzonen (10, 11, 12) in einer Reihe angeordnet sind.

FIG 1

FIG 2

FIG 3

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| X | DE-A-1 949 327 (SIEMENS) * Seite 5, Zeile 17 - Seite 6, Zeile 11; Figuren 1-8 * | 1-3 | H 01 L 29/72 H 01 L 29/08 |
| | --- | | |
| A | GB-A-1 539 688 (V.Y. KREMLEV u.a.) | | |
| | --- | | |
| A | IBM TECHNICAL DISCLOSURE BULLETIN, Band 13, Nr. 5, Oktober 1970, Seiten 1099-1100, New York, US; M.B. VORA: "Epitaxial base transistor" | | |
| | --- | | |
| A | FR-A-2 085 407 (R.T.C.) | | |
| | ----- | | |

| | | | RECHERCHIERTE SACHGEBIETE (Int. Cl.4) |
|---|---|---|---|
| | | | H 01 L 29 |

Der vorliegende Recherchenbericht wurde für alle Patentansprüche erstellt.

| Recherchenort DEN HAAG | Abschlußdatum der Recherche 27-11-1985 | Prüfer PELSERS L. |
|---|---|---|